# EUROPÄISCHE PATENTSCHRIFT

(11) **EP 4 064 546 B1**
(45) Veröffentlichungstag und Bekanntmachung des Hinweises auf die Patenterteilung: **08.10.2025**
(21) Anmeldenummer: 21164446.3
(22) Anmeldetag: 24.03.2021
(51) Int. Cl.: H02M 7/483, H02M 1/00

(54) **STROMRICHTER UND VERFAHREN ZUM BETREIBEN DES STROMRICHTERS**
POWER CONVERTER AND METHOD FOR OPERATING THE POWER CONVERTER
CONVERTISSEUR ET PROCÉDÉ DE FONCTIONNEMENT DU CONVERTISSEUR

(43) Veröffentlichungstag der Anmeldung: 28.09.2022
(73) Patentinhaber: Siemens Energy Global GmbH & Co. KG, 81739 München (DE)
(72) Erfinder: Alvarez Valenzuela, Rodrigo Alonso, 90408 Nürnberg (DE); Dorn, Jörg, 96155 Buttenheim (DE); Gambach, Herbert, 91080 Uttenreuth (DE); Wang, Yeqi, 91094 Langensendelbach (DE)

(56) Entgegenhaltungen:
- CN-A- 112 464 443
- ZHANG YI ET AL: "Impact of lifetime model selections on the reliability prediction of IGBT modules in modular multilevel converters", 2017 IEEE ENERGY CONVERSION CONGRESS AND EXPOSITION (ECCE), IEEE, 1 October 2017 (2017-10-01), pages 4202 - 4207, XP033247373, DOI: 10.1109/ECCE.2017.8096728
- ZHANG YI ET AL: "Simplified Estimation of the Junction Temperature Fluctuation at the Output Frequency for IGBT Modules in Modular Multilevel Converters", 2018 IEEE ENERGY CONVERSION CONGRESS AND EXPOSITION (ECCE), IEEE, 23 September 2018 (2018-09-23), pages 1 - 5, XP033464223, DOI: 10.1109/ECCE.2018.8558180
- VELAZCO DIEGO ET AL: "IGBT Lifetime Estimation in a Modular Multilevel Converter for bidirectional point-to-point HVDC application", 2020 22ND EUROPEAN CONFERENCE ON POWER ELECTRONICS AND APPLICATIONS (EPE'20 ECCE EUROPE), EPE ASSOCIATION, 7 September 2020 (2020-09-07), pages 1 - 10, XP033835453, DOI: 10.23919/EPE20ECCEEUROPE43536.2020.9215880

## Beschreibung

Die Erfindung betrifft ein Verfahren zum Betreiben eines Stromrichters, der Stromrichterarme umfasst, wobei jeder Stromrichterarm Schaltmodule mit jeweils mehreren Halbleiterschaltern und einem Energiespeicher aufweist, bei dem anhand eines Zustandsmodells des Stromrichters wenigstens ein Temperaturwert für den Stromrichter ermittelt wird, wobei das Ermitteln unter Gewinnung zeitbezogener Temperaturwerte wiederholt wird. Die Stromrichterarme können beispielsweise zwischen je einer Gleichspannungsseite und einer Wechselspannungsseite des Stromrichters (AC-DC-Wandler), zwischen je einer ersten und einer zweiten Wechselspannungsseite des Stromrichters (AC-AC-Wandler), zwischen je einer ersten und einer zweiten Gleichspannungsseite des Stromrichters (DC-DC-Wandler) schaltbar oder auch mit Phasenleitungen eines Wechselspannungsnetzes verbindbar sein. Die im jeweiligen Stromrichterarm angeordneten Schaltmodule sind geeigneterweise in einer elektrischen Reihenschaltung angeordnet.

Ein artgemäßes Verfahren ist aus der WO 2020/125968 Al bekannt. Gemäß dem bekannten Verfahren wird der Temperaturwert mittels einer geeigneten Modellierung des Zustandsmodells gewonnen.

Zur Aufrechterhaltung der Zuverlässigkeit des Stromrichters muss dieser in gewissen Zeitabständen gewartet werden. Die Wartung muss insbesondere vor dem Ablauf dessen verbleibender Lebensdauer erfolgen. Während eines Wartungsvorgangs werden üblicherweise Hardwarekomponenten, insbesondere Halbleiter bzw. Halbleiterschalter sowie passive Komponenten, wie Drosseln und Kondensatoren, auf etwaige Ausfälle hin überprüft und ggf. ausgetauscht. Dabei sind die Abstände zwischen den Wartungen (Wartungsintervalle) fest vorgegeben, ohne Berücksichtigung kritischer oder unkritischer Betriebe bzw. Betriebszustände des Stromrichters während des vergangenen Wartungsintervalls.

Neben der Planung nach festen Wartungsintervallen besteht ebenfalls die Möglichkeit, die Temperatur der Halbleiter (insbesondere einer Sperrschichttemperatur) und der passiven Komponenten zu messen. Die Wartungsintervalle können dann unter Berücksichtigung der gemessenen Temperaturen entsprechend variiert werden. Allerdings ist die Messung der internen Sperrschichttemperatur nur mit erheblichem Aufwand (insbesondere Kostenaufwand) möglich. Fehlende Genauigkeit der Messung führt dabei oftmals dazu, dass insbesondere die Temperaturen bei dynamischen Vorgängen nicht ausreichend erfasst und übermittelt werden können. Die Wartungsintervalle können dementsprechend nicht zuverlässig festgelegt werden.

In dem Beitrag von Zhang et al.: "Impact of lifetime model selections on the reliability prediction of IGBT modules in modular multilevel converters", IEEE 2017, sind Methoden zur Schätzung der Lebensdauer eines MMC beschrieben, die unterschiedliche Temperaturmodelle eines MMC-Moduls berücksichtigen.

Eine weitere Untersuchung von Modellen der Sperrschichttemperatur eines Halbleiters eines MMC ist aus dem Beitrag von Zhang et al.: "Simplified Estimation of the Junction Temperature Fluctuation at the Output Frequency for IGBT Modules in Modular Multilevel Converters", IEEE 2018, bekannt.

Weitere Methoden zur Schätzung der Sperrschichttemperatur sind in dem Beitrag von Velazco et al.: "IGBT Lifetime Estimation in a Modular MultilevelConverter for bidirectional point-to-point HVDC application",2020, sowie in der CN 112 464 443 A offenbart.

Die Aufgabe der Erfindung ist es, ein artgemäßes Verfahren vorzuschlagen, das die Zuverlässigkeit des Stromrichters weiter verbessert.

Die Aufgabe wird durch die Merkmale des Verfahrens-Anspruchs 1 und des Vorrichtungs-Anspruchs 9 gelöst. Die abhängigen Ansprüche definieren vorteilhafte Ausgestaltungen der Erfindung.

Zur effizienten Gestaltung des Wartungszyklus und zur Verlängerung der Wartungsintervalle ist es vorteilhaft, die verbleibende Lebensdauer der Halbleiterschalter, der passiven Komponenten und damit auch des gesamten Stromrichters im Voraus vorherzusagen. Dabei haben die Anzahl (thermisch-) dynamischer Vorgänge bzw. thermische Zyklen einen großen Einfluss auf die zu erwartende verbleibende Lebensdauer. Die dynamischen Vorgänge können dabei anhand der innerhalb eines betrachteten Zeitraumes aufgetretenen Temperaturhübe untersucht bzw. bewertet werden. Die Temperaturwerte sind dazu zeitbezogen, d.h. jedem der Temperaturwerte ist ein entsprechender Zeitpunkt zugeordnet. Ein Temperaturhub entspricht einer Differenz zwischen einem maximalen und einem minimalen Temperaturwert innerhalb eines vorgegebenen Zeitintervalls, beispielsweis einer Netzperiode (in diesem Fall bezogen auf eine Nennfrequenz eines angeschlossenen Wechselspannungsnetzes). Die Kenntnis von thermischen Zyklen der Halbleiter und der passiven Komponenten erlaubt es Rückschlüsse auf den Gesundheitszustand des Umrichters zu ziehen. Ein Strom- und Spannungsabhängiges thermisches Modell bzw. Zustandmodell erlaubt daher eine Vorhersage bzw. eine Schätzung der voraussichtlich verbleibenden Lebensdauer und damit auch der notwendigen Wartungsintervalle. Dabei werden den Verfahren zur Prädiktion, unter Berücksichtigung dynamischer Vorgänge, speziell bei Fehlerfällen, alle wichtigen Daten geliefert. Damit sind sowohl bessere Life Time-Analysen möglich als auch den End-oflife-Zeitpunkt schätzungsweise zu bestimmen. Die Schätzung ermöglicht vorteilhaft eine Ausrichtung der Wartung nach zwingend erforderlichen Wartungsterminen anstelle von festen Wartungsintervallen, wodurch der Wartungsaufwand signifikant reduziert werden kann, da die Wartung nur dann durchgeführt wird, wenn sie wirklich notwendig ist. Daraus ergibt sich als unmittelbare Folge eine längere Nutzbarkeit und Verfügbarkeit des Umrichters (high disponibility). Im einfachsten Fall wird zeitwiederholt ein "gemittelter" Temperaturwert für den gesamten Stromrichter bestimmt, der sich aus den Informationen über einige, vorzugsweise alle, relevanten Komponenten des Stromrichters ergibt. Aus dem stromrichterbezogenen Temperaturwert kann eine Schätzung der verbleibenden Lebensdauer des Stromrichters ermittelt werden. Die Schätzung basiert auf einer Bestimmung der Anzahl und Höhe der Temperaturhübe, wobei die Anzahl von Temperaturhüben, die eine vorbestimmte Mindesthöhe aufweisen, mit vom Hersteller der Halbleiterschalter vorgegebenen Daten verglichen wird. Diese Daten umfassen eine Gesamtanzahl der Temperaturhübe der vorbestimmten Mindesthöhe, die ein Halbleiterschalter im Betrieb bis zu einem Ausfall durchlaufen kann. Wird die mittels der Temperaturwerte bestimmte Anzahl der Temperaturhübe mit der Gesamtanzahl verglichen, so können daraus (insbesondere aus der Differenz zwischen der Gesamtzahl und der Anzahl der gemäß den Temperaturwerten bereits durchlaufener Temperaturhübe) Rückschlüsse auf die verbleibende Lebensdauer gezogen werden. Gemäß einem Beispiel könnte eine Nenntemperatur für einen Halbleiterschalter mit 110°C vorgegeben sein. Die (beispielsweise vom Hersteller des Halbleiterschalters) vorgegebene Anzahl der Temperaturhübe von 20 K, die der Halbleiterschalter bis zu seinem Ausfall durchlaufen kann, sei mit n bezeichnet. Wird nun aus dem Temperaturwerten die Anzahl nh der Temperaturhübe der Höhe 20 K gezählt, so kann beispielweise mit einer Wartung gewartet werden, bis diese Anzahl nh den Wert n-m erreicht, wobei m eine Sicherheitsmarge darstellt.

Bei der Schätzung der verbleibenden Lebensdauer können insbesondere auch statistische Verfahren verwendet werden. Als Ergebnis der Schätzung kann dann eine Wahrscheinlichkeitsverteilung ermittelt werden, wobei jedem Wert der verbleibenden Lebensdauer im Sinne eines statistischen Ereignisses eine entsprechende Ereignis-Wahrscheinlichkeit zugeordnet wird.

Diese Vorgehensweise erlaubt eine statistische Auswertung der Schätzergebnisse. Die Wahrscheinlichkeiten können über einen längeren Zeitraum mit in der Wirklichkeit aufgetretenen Ereignissen (z.B. einen tatsächlichen Ausfall einer Komponente) verglichen werden (mit einer darauf basierten Anpassung des Zustandsmodells und/oder der Schätzung selbst), so dass eine noch genauere Vorhersage bzw. Schätzung der verbleibenden Lebensdauer ermöglicht ist.

Bevorzugt wird das Ermitteln der Temperaturwerte in Zeitabständen von weniger als 1 Sekunde, besonders bevorzugt in Zeitabständen von weniger als 100 Mikrosekunden durchgeführt. Auf diese Weise ist eine besonders fein aufgelöste und damit zuverlässige Berechnung der Temperaturhübe ermöglicht. Dies ist vorteilhaft, da dynamische und transiente Vorgänge teilweise mit der doppelten/vierfachen Netzfrequenz auftreten können, wodurch eine Abtastzeit von mindestens 5ms bzw. 2.5ms (gemäß dem Theorem von Shannon) notwendig ist. Insbesondere kann die Höhe des Temperaturhubs durch ein Addieren von Differenzen zwischen zwei aufeinanderfolgenden Temperaturwerten über einen vorgegebenen Zeitraum bestimmt werden. Der vorgegebene Zeitraum kann beispielsweise eine halbe, eine ganze oder ein Vielfaches einer Netzperiode sein.

Insbesondere kann die Höhe des Temperaturhubs allgemein aus einer Differenz zwischen zwei Temperaturwerten ermittelt werden, beispielsweise einem minimalen und einem maximalen Temperaturwert innerhalb eines vorgegebenen Zeitintervalls (bzw. zwischen nächstliegenden minimalen und maximalen Temperaturwerten). Darüber hinaus ist es auch denkbar, dass, wie zuvor erwähnt, zwei aufeinanderfolgende Temperaturwerte herangezogen werden. In einem solchen Fall können zur Ermittlung des Temperaturhubs mehrere Differenzen addiert werden.

Vorzugsweise berücksichtigt das Zustandsmodell bei der Berechnung der Temperaturwerte zumindest folgende Stromrichtergrößen: Energiespeicherspannungen, Schaltzustände und Schaltfrequenzen zumindest einiger Schaltmodule sowie Armspannungen und Armströme des oder der betreffenden Stromrichterarme. Das Zustandsmodell kann in einer Regelungseinrichtung des Stromrichters implementiert sein, insbesondere in einem Stromregelungssystem ("current control system"). Das Zustandsmodell umfasst bevorzugt ein Temperaturmodell, mittels dessen die momentane Temperatur bzw. der entsprechende momentane Temperaturwert berechnet (insbesondere geschätzt) wird. Der Temperaturwert des Stromrichters kann dabei ein Temperaturwert eines "mittleren Schaltmoduls" sein. Das bedeutet, dass im Temperaturmodell ein Schaltmodul modelliert wird, das im einfachsten Fall alle Schaltmodule des Stromrichters, geeigneterweise alle Schaltmodule eines Stromrichterarmes repräsentiert. Die Temperatur (Temperaturwert) eines Schaltmoduls wird zweckmäßigerweise wiederum als eine mittlere (oder alternativ höchste) Temperatur dessen Halbleiter bzw. deren Sperrschichten (junction temperature) verstanden. Es werden bestenfalls alle Sperrschichttemperaturen des mittleren Schaltmoduls (also für eine Halbbrücke die beiden IGBT- und die beiden Dioden-Junction-Temperaturen) berechnet und können entsprechend in die weitere Verarbeitung einfließen. Verfahren zu einer Temperatur- bzw. Zustandsmodellierung von Halbleitern sind aus der Fachliteratur bekannt. Als Beispiele können hier der Beitrag von Beczkowski et al. "Complete Loss and Thermal Model of Power Semiconductors Including Device Rating Information", IEEE Transactions on Power Electronics, 2015, und der Beitrag von Alavi et al. "Assessment of thermal network models for estimating IGBT junction temperature of a buck converter", 2017 8th Power Electronics, Drive Systems & Technologies Conference (PEDSTC), genannt werden. Die Energiespeicherspannung ist die momentan an einem der Energiespeicher eines der Schaltmodule anstehende Spannung. Die Energiespeicherspannung kann mittels einer geeigneten Messvorrichtung am oder im Schaltmodul erfasst und an die Regelungseinrichtung übermittelt werden. Der Schaltzustand eines Schaltmoduls gibt an, ob der Energiespeicher des Schaltmoduls sich momentan im Strompfad des Stromrichterarmes befindet oder überbrückt ist ("ein" oder "aus"). Die Berücksichtigung des Schaltzustandes im Zustandsmodell bzw. Temperaturmodell ist vorteilhaft, weil der Schaltzustand angibt, wo im Stromrichter die Temperatur momentan ansteigt bzw. Verluste entstehen. Die Schaltfrequenz ist geeigneterweise als Schaltpaarhäufigkeit definiert (Anzahl der Einschaltvorgänge+Ausschaltvorgänge/Zeitintervall; Zeitinvervall ist beispielsweise gleich der Netzperiode). Die Berücksichtigung der Schaltfrequenzen im Zustandsmodell bzw. Temperaturmodel ist vorteilhaft, weil die Schaltfrequenz die Höhe der Schaltverluste beeinflusst. Die Armspannung ist die momentan an einem Stromrichterarm anstehende Spannung. Die Armspannungen werden für alle Stromrichterarme kontinuierlich mittels Spannungsmessvorrichtungen gemessen und können an die Regelungseinrichtung übermittelt werden. Der Armstrom ist der durch den zugeordneten Stromrichterarm momentan fließende Strom. Der Armstrom bestimmt u.a. auch die Stromflussrichtung und damit im günstigsten Fall auch, welcher Halbleiter stromführend ist (IGBT/Diode). Die Armströme der Stromrichterarme werden ebenfalls kontinuierlich mittels Strommesseinrichtungen gemessen und können an die Regelungseinrichtung übermittelt werden. Als weiterer Eingangsparameter für das Zustandsmodell wird ein Redundanzverbrauchswert verwendet. Der Redundanzverbrauchswert gibt an, wie viele Schaltmodule in einem Stromrichterarm in der Vergangenheit bereits ausgefallen bzw. fehlerhaft sind, wodurch es bekannterweise zu einer stärkeren Belastung der verfügbaren/gesunden Schaltmodule kommt.

Vorzugsweise wird die Schätzung der verbleibenden Lebensdauer unter Berücksichtigung eines Lebensdauermodells des Halbleiterschalters durchgeführt. Wie bereits zuvor ausgeführt, kann ein einfaches Modell eine vorgegebene Anzahl von Temperaturhüben beinhalten. Darüber hinaus sind jedoch auch andere, detailliertere Lebensdauermodelle möglich. Beispielsweise können die Lebensdauermodelle weitere Halbleiterparameter, Umwelteinflüsse oder Berücksichtigung von unterschiedlichen Höhen der Temperaturhübe beinhalten. Genauere Lebensdauermodelle erlauben eine verbesserte Vorhersage, sind jedoch meist relativ aufwendig.

Wenn die geschätzte verbleibende Lebensdauer eine vorgegebene Schwelle unterschreitet, wird vorzugsweise ein Signal für eine Wartungsanweisung ausgegeben. Das Signal kann beispielsweise eine einfache Anzeige aufweisen, es kann aber auch beispielsweise die voraussichtliche Lebensdauer enthalten sowie weitere Informationen über den Stromrichterzustand. Das Signal wird bevorzugt an den Betreiber des Stromrichters übermittelt werden.

Gemäß einer Ausführungsform der Erfindung werden die Temperaturwerte über ein stromrichterexternes Datennetzwerk an eine externe Datenverarbeitungseinrichtung übermittelt. Das Schätzen der verbleibenden Lebensdauer wird mittels der externen Datenverarbeitungseinrichtung durchgeführt. Grundsätzlich können die Life Time Analysen sowohl in der Stromrichterregelung, der übergeordneten Regelung oder Steuerung, als auch extern durchgeführt werden. Beispielsweise kann die externe Datenverarbeitungseinrichtung sich in der sogenannten "cloud" befinden. Damit entfallen etwaige Einschränkungen bezüglich der Speicher- und Rechenkapazität, die sich aus den u.U. begrenzten Ressourcen der umrichterinternen Stromrichterregelung ergeben. Die in der cloud verarbeiteten Daten können anschließend auch dem Anwender bzw. Betreiber zur Verfügung gestellt werden.

Gemäß einer weiteren Ausführungsform der Erfindung werden die Temperaturwerte zur Erweiterung der Datengrundlage mit Temperaturwerten weiterer Stromrichter abgeglichen. Somit erlauben die gewonnen Daten auch einen Abgleich mit Auswertungen und Erkenntnisse anderer Umrichter(stationen), wodurch die statistischen Werte und Modelle laufend verifiziert und verbessert werden können.

Die Erfindung betrifft ferner einen Stromrichter der Stromrichterarme umfasst, wobei jeder Stromrichterarm Schaltmodule mit jeweils mehreren Halbleiterschaltern und einem Energiespeicher aufweist.

Die Aufgabe der Erfindung ist es, einen solchen Stromrichter vorzuschlagen, der möglichst effizient und zuverlässig im Betrieb ist.

Die Aufgabe wird bei einem artgemäßen Stromrichter erfindungsgemäß dadurch gelöst, dass wenigstens eine Datenverarbeitungseinrichtung vorgesehen ist, die zum Durchführen eines erfindungsgemäßen Verfahrens eingerichtet ist.

Die Vorteile des erfindungsgemäßen Stromrichters ergeben sich insbesondere aus den im Zusammenhang mit dem erfindungsgemäßen Verfahren beschriebenen Vorteilen.

Der Stromrichter kann beispielsweise für eine HGÜ-Anwendung oder auch für eine FACTS-Anwendung vorgesehen und insbesondere ein modularer Mehrstufenumrichter sein. Die Schaltmodule können zum Beispiel die dem Fachmann bekannten Halbbrücken-Schaltmodule oder Vollbrücken-Schaltmodule sein.

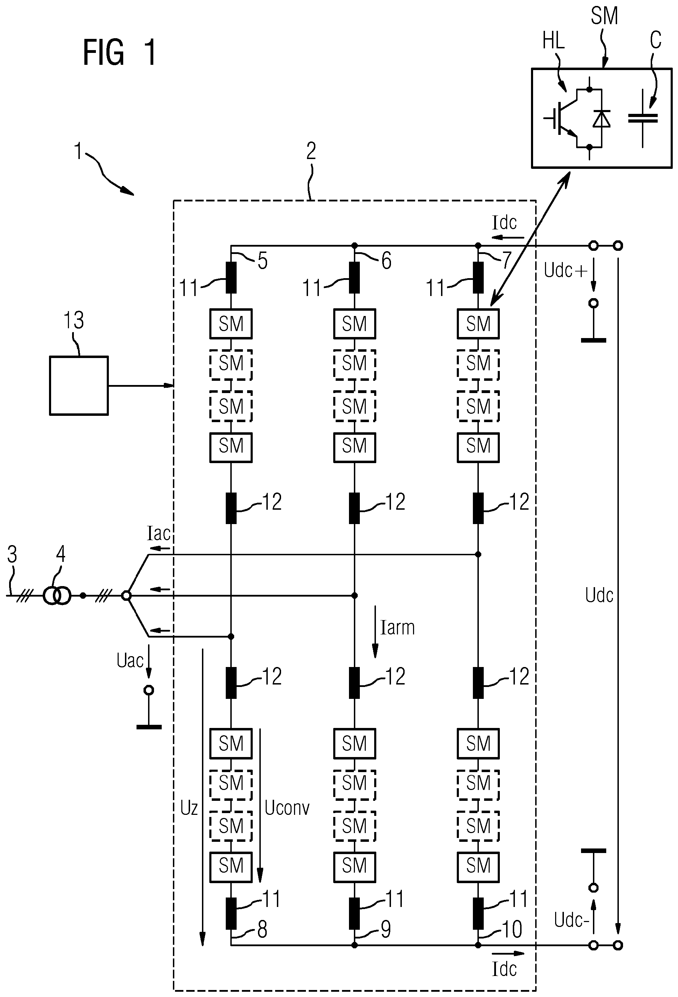

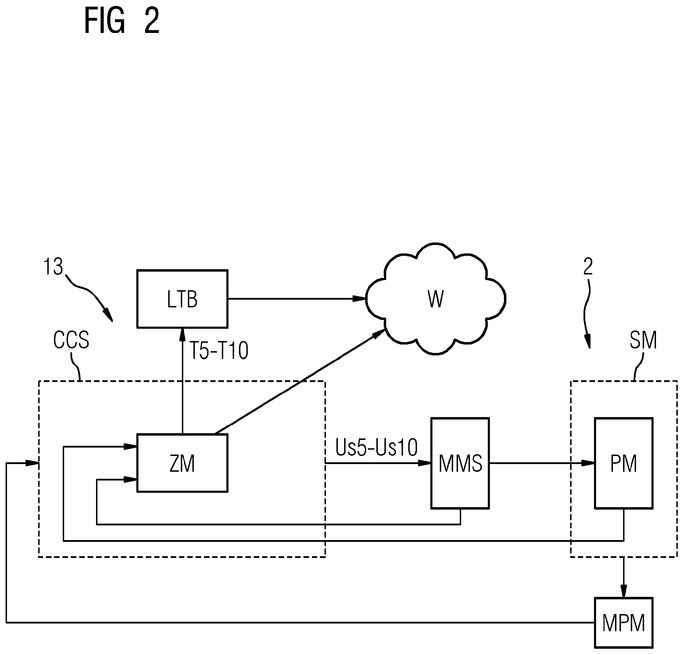

Die Erfindung wird nachfolgend anhand der Figuren 1 und 2 weiter erläutert.
Figur 1 zeigt einen erfindungsgemäßen Stromrichter in einer schematischen Darstellung;
Figur 2 zeigt ein Ausführungsbeispiel einer Regelungseinrichtung für einen erfindungsgemäßen Stromrichter in einer schematischen Darstellung.

In Figur 1 ist eine Stromrichteranordnung 1 dargestellt. Die Stromrichteranordnung 1 umfasst einen Stromrichter 2, der ein modularer Mehrstufenstromrichter (MMC) ist. Der MMC ist im dargestellten Beispiel zur Umwandlung einer Wechselspannung eines Wechselspannungsnetzes 3, mit dem der MMC 2 mittels eines Netztransformators 4 verbunden ist, in eine Gleichspannung Ude umzuwandeln.

Der MMC 2 umfasst sechs Stromrichterarme 5-10, die miteinander in einer Doppelsternschaltung verbunden sind. Jeder der gleichartig aufgebauten Stromrichterarme 5-10 umfasst zwei Arminduktivitäten 11, 12 sowie je eine Reihenschaltung von Schaltmodulen SM. In dem in Figur 1 dargestellten Ausführungsbeispiel sind alle Schaltmodule SM gleichartig aufgebaut, was jedoch im Allgemeinen nicht notwendig ist. Auch die Anzahl der Schaltmodule SM in jedem Stromrichterzweig 5-10 ist grundsätzlich beliebig und an die jeweilige Anwendung anpassbar. Die Schaltmodule SM können beispielsweise Vollbrücken-Schaltmodule oder Halbbrücken-Schaltmodule sein. Jedes Schaltmodul SM umfasst steuerbare Halbleiterschalter, z.B. IGBT, IGCT oder dergleichen (ein Vollbrücken-Schaltmodul mindestens vier Halbleiterschalter, ein Halbbrücken-Schaltmodul mindestens zwei Halbleiterschalter), geeigneterweise den Halbleiterschaltern zugeordnete Freilaufdioden sowie einen Energiespeicher (zum Beispiel in Form eines Kondensators) sowie eine Steuerungsbaugruppe, mittels der die Halbleiterschalter angesteuert werden können. Bezüglich des Aufbaus der genannten Beispiele für Schaltmodule wird hiermit auf die bereits genannte Druckschrift WO 2020/125968 Al verwiesen.

Der Stromrichter 2 umfasst ferner eine zentrale Regelungseinrichtung 13, die zum Regeln des MMC 2 (bzw. der Regelungsgrö-ßen) und zum Ansteuern der Schaltmodule SM eingerichtet ist. Die Regelungseinrichtung 13 erhält von einer übergeordneten Instanz Vorgaben bezüglich der geforderten Wirkleistung und Blindleistung, ggf. auch Spannung und/oder Strom, die von der Regelungseinheit in Sollwerte von Regelungsparametern, z.B. von Spannung und Strom umgesetzt werden. Die Regelungsparameter können somit insbesondere eine wechselspannungsseitige Spannung Uac, ein wechselspannungsseitiger Strom Iac, ein gleichspannungsseitiger Strom Idc und/oder eine gleichspannungsseitige Spannung Udc sein. In einem Stromrichter, der als ein symmetrischer Monopol konzipiert ist, können eine Spannung Udc+ zwischen dem positiven Gleichspannungspol und dem Erdpotenzial und eine Spannung Udc- zwischen dem negativen Gleichspannungspol und dem Erdpotenzial von Bedeutung sein. Im hier dargestellten Beispiel sind der Armstrom (der durch einen der Stromrichterarme fließende Strom) jeweils die Regelgröße und die Armspannung entsprechend die Stellgröße der Stromrichteranordnung 1.

In Figur 2 ist die Regelungseinrichtung 13 für den Stromrichter 2 (beispielsweise den Stromrichter 2 der Figur 1) dargestellt. Die Regelungseinrichtung 13 umfasst mehrere Komponenten. Ein Modul-Management-System MMS ist jedem der Schaltmodule SM des Stromrichters 2 zugeordnet. Das MMS ist dazu eingerichtet, vom zugeordneten Schaltmodul SM Zustandsdaten des Schaltmoduls SM zu ermitteln bzw. zu übermittelt zu bekommen und diese an ein zentrales Stromregelungssystem, Current Control System CCS zu übermitteln. Mittels eines Measurement & Processing Module MPM werden Messgrößen wie ein im entsprechenden Stromrichterarm fließender erfasst und verarbeitet.

Unabhängig von der Realisierung der übrigen Komponenten können die am Schaltmodul SM gemessenen Messgrößen vor der Weiterleitung bzw. Übermittlung an das CCS verarbeitet, insbesondere gefiltert (z.B. tiefpassgefiltert) oder entrauscht werden (durch Herausfiltern hochfrequenter Signalanteile).

Das Stromregelungssystem CCS umfasst ein Zustandsmodell-Modul ZM, das in der Realisierung kein gesondertes Hardware-Modul sein muss, sondern auch als eine Software-Funktion innerhalb der Regelungshardware implementiert sein kann. Im Zustandsmodell-Modul ZM ist ein Zustandsmodell des Stromrichters 2 implementiert bzw. hinterlegt. Das Zustandsmodell kann beispielsweise in Form einer oder mehrerer Differenzialgleichungen realisiert sein, die rechnerische Eingangsgrößen in ebensolche Ausgangsgrößen umwandeln können. Im hier dargestellten Beispiel gehen zumindest die folgenden Eingangsgrößen in das Zustandsmodell ein: Energiespeicherspannungen aller Schaltmodule SM des Stromrichters 2 (diese werden vom MMS geliefert), Schaltzustände aller Schaltmodule SM (diese werden von den Schaltmodulen übermittelt) und Schaltfrequenzen aller Schaltmodule SM (diese im jeweiligen MMS ermittelt und an das CCS übermittelt) sowie Armspannungen Uconv und Armströme Iarm der Stromrichterarme 5-10 (von der MPM übermitteln/gemessen). Als Ausgangsgrößen werden (skalare) zeitbezogene Temperaturwerte T5-T10 für jeden der Stromrichterarme 5-10 am Ausgang des ZM bereitgestellt. Die Bereitstellung der Temperaturwerte findet in zeitlichen Abständen statt, die dem Takten des Stromregelungssystemes entspricht, z.B. in Abständen von 50 Mikrosekunden. Mittels eines Regelungsmoduls (in Figur 2 nicht sichtbar) können basierend auf den Temperaturwerten T5-T10 sowie weiteren Stromrichtergrößen Anpassungen an den Stellspannungen Us5-Us10 bestimmt bzw. berechnet und an das jeweilige MMS übermittelt werden. Das jeweilige MMS übersetzt die Stellspannungen anschließend in geeignete Schaltbefehle für die zugeordneten Schaltmodule SM und übermittelt entsprechend diese Schaltbefehle an die einzelnen Schaltmodule SM.

Die Temperaturwerte T5-T10 werden ferner an eine stromrichterexterne Datenverarbeitungseinrichtung übermittelt, die ein Modul LTB umfasst, das zur Schätzung der Lebensdauer für den Stromrichter 2 eingerichtet ist.

Zugleich bietet das Konzept auch die Möglichkeit, die Temperaturwerte jederzeit in Echtzeit darstellen und diese auch mittels der sogenannten cloud W einem Kunden zur Verfügung stellen zu können. Ein Abgleich mit Temperaturwerten anderer Stromrichteranordnungen ist ebenfalls möglich, wodurch die gewonnenen Echtzeitdaten zur Verbesserung von Betriebsmodi und Algorithmen genutzt werden können. Zudem erlaubt die Kenntnis über die aktuellen Halbleiterverluste bzw. Sperrschichttemperaturen eine Optimierung auf Stationsebene, wie z.B. durch Anpassung des Kühlkreislaufes, Anpassung der Sollwerte etc.

Das Modul LTB umfasst dort hinterlegte Daten, beispielsweise von Herstellern der im Stromrichter 2 verbauten Halbleiterschalter HL, die Informationen über Parameter und Verhalten der Halbleiter bei Temperaturänderungen umfassen. Die Berechnung der verbleibenden Lebensdauer kann zum Beispiel auf einer Formel für den Lebensdauerverbrauch eines Halbleiters, Nf = a * (DeltaT)^b, basieren, wobei Nf eine Anzahl von Lastzyklen, DeltaT ein vorgegebener Temperaturhub, a und b vom Hersteller genannte Halbleiterparameter sind. Am Ausgang des Moduls LTB wird eine Information über die verbleibende Lebensdauer bereitgestellt. Diese Information wird an den Betreiber des Stromrichters 2 übermittelt, bzw. innerhalb der cloud W zur Verfügung gestellt. Zugleich kann eine Wartungsanweisung erzeugt und dem Betreiber ebenfalls zur Verfügung gestellt werden, falls die Schätzung der restlichen Lebensdauer eine verbleibende Lebensdauer ergibt, die unterhalb einer vorbestimmten Schwelle liegt.

## Patentansprüche

1. Verfahren zum Betreiben eines Stromrichters (2), der Stromrichterarme (5-10) umfasst, wobei jeder Stromrichterarm (5-10) Schaltmodule (SM) mit jeweils mehreren Halbleiterschaltern (HL) und einem Energiespeicher (K) aufweist, bei dem
anhand eines Zustandsmodells des Stromrichters (2) ein Temperaturwert (T5-T10) für den Stromrichter (2) ermittelt wird, wobei das Ermitteln unter Gewinnung zeitbezogener Temperaturwerte (T5-T10) wiederholt wird,
aus den Temperaturwerten (T5-T10) eine Anzahl und eine Höhe aufgetretener Temperaturhübe ermittelt wird, und auf der Basis der ermittelten Anzahl und Höhe eine verbleibende Lebensdauer für den Stromrichter (2) geschätzt wird, wobei die Anzahl von Temperaturhüben, die eine vorbestimmte Mindesthöhe aufweisen, mit vom Hersteller der Halbleiterschalter vorgegebenen Daten verglichen wird, und wobei das Zustandsmodell bei der Berechnung des Temperaturwertes zumindest folgende Stromrichtergrößen berücksichtigt: Energiespeicherspannungen, Schaltzustände und Schaltfrequenzen zumindest einiger Schaltmodule (SM), eine Armspannung und einen Armstrom des Stromrichterarmes (5-10) sowie einen Redundanzverbrauchswert, welcher angibt, wie viele Schaltmodule in einem Stromrichterarm in der Vergangenheit bereits ausgefallen bzw. fehlerhaft sind.

2. Verfahren nach Anspruch 1, wobei der verbleibenden Lebensdauer eine Ereignis-Wahrscheinlichkeit zugeordnet wird.

3. Verfahren nach einem der vorangehenden Ansprüche, wobei das Ermitteln der Temperaturwerte in Zeitabständen von weniger als 1 Sekunde wiederholt wird.

4. Verfahren nach einem der vorangehenden Ansprüche, wobei die Höhe des Temperaturhubs aus einer Differenz zwischen zwei Temperaturwerten ermittelt wird.

5. Verfahren nach einem der vorangehenden Ansprüche, wobei die Schätzung der verbleibenden Lebensdauer unter Berücksichtigung eines Lebensdauermodells des Halbleiterschalters (HL) durchgeführt wird.

6. Verfahren nach einem der vorangehenden Ansprüche, wobei, wenn die geschätzte verbleibende Lebensdauer eine vorgegebene Schwelle unterschreitet, ein Signal für eine Wartungsanweisung ausgegeben wird.

7. Verfahren nach einem der vorangehenden Ansprüche, wobei die Temperaturwerte über ein stromrichterexternes Datennetzwerk an eine externe Datenverarbeitungseinrichtung (LTB) übermittelt werden und das Schätzen der verbleibenden Lebensdauer mittels der externen Datenverarbeitungseinrichtung (LTB) durchgeführt wird.

8. Verfahren nach einem der vorangehenden Ansprüche, wobei die Temperaturwerte zur Erweiterung der Datengrundlage mit Temperaturwerten weiterer Stromrichter abgeglichen werden.

9. Stromrichter (2) der Stromrichterarme (5-10) umfasst, wobei jeder Stromrichterarm (5-10) Schaltmodule (SM) mit jeweils mehreren Halbleiterschaltern (HL) und einem Energiespeicher (C) aufweist,
**gekennzeichnet durch**
wenigstens eine Datenverarbeitungseinrichtung (13), die zum Durchführen eines Verfahrens nach den Ansprüchen 1 bis 8 eingerichtet ist.

## Claims

1. Method for operating a power converter (2) that comprises power converter arms (5-10), wherein each power converter arm (5-10) has switching modules (SM) that each have a plurality of semiconductor switches (HL) and an energy store (K), in which a temperature value (T5-T10) for the power converter (2) is ascertained on the basis of a state model of the power converter (2), wherein the ascertainment is repeated so as to obtain timerelated temperature values (T5-T10),
a number and a magnitude of temperature swings that have occurred are ascertained from the temperature values (T5-T10), and a remaining service life for the power converter (2) is estimated based on the ascertained number and magnitude, wherein the number of temperature swings that have a predetermined minimum magnitude is compared with data predefined by the manufacturer of the semiconductor switches, and wherein the state model takes at least the following power converter variables into account when calculating the temperature value: energy store voltages, switching states and switching frequencies of at least some switching modules (SM), an arm voltage and an arm current of the power converter arm (5-10), and a redundancy consumption value that indicates the number of switching modules in a power converter arm that have already failed in the past or are faulty.

2. Method according to Claim 1, wherein an event probability is assigned to the remaining service life.

3. Method according to either of the preceding claims, wherein the ascertainment of the temperature values is repeated at intervals of time of less than 1 second.

4. Method according to one of the preceding claims, wherein the magnitude of the temperature swing is ascertained from a difference between two temperature values.

5. Method according to one of the preceding claims, wherein the remaining service life is estimated taking a service life model of the semiconductor switch (HL) into account.

6. Method according to one of the preceding claims, wherein a signal for a maintenance instruction is output if the estimated remaining service life falls below a predefined threshold.

7. Method according to one of the preceding claims, wherein the temperature values are transmitted to an external data processing device (LTB) via a data network that is external to the power converter, and the remaining service life is estimated by means of the external data processing device (LTB).

8. Method according to one of the preceding claims, wherein the temperature values are collated with temperature values of further power converters in order to expand the data basis.

9. Power converter (2) that comprises power converter arms (5-10), wherein each power converter arm (5-10) has switching modules (SM) that each have a plurality of semiconductor switches (HL) and an energy store (C),
**characterized by**
at least one data processing device (13) that is designed to carry out a method according to Claims 1 to 8.

## Revendications

1. Procédé pour faire fonctionner un convertisseur (2), qui comprend des bras (5-10) de convertisseur, dans lequel chaque bras (5-10) de convertisseur a des modules (SM) de coupure ayant respectivement plusieurs interrupteurs (HL) à semiconducteur et un accumulateur (K) d'énergie, dans lequel
à l'aide d'un modèle d'état du convertisseur (2) on détermine une valeur (T5-T10) de la température pour le convertisseur (2), dans lequel on répète la détermination en obtenant des valeurs (T5-T10) de température rapportées au temps,
à partir des valeurs (T5-T10) de température on détermine un nombre et une hauteur des élévations de température, qui se produisent, sur la base du nombre et de la hauteur déterminée on estime une durée de vie restante du convertisseur (2), dans lequel on compare le nombre des élévations de température, qui ont une hauteur minimum déterminée à l'avance, à des données données à l'avance par le fabricant des interrupteurs à semiconducteur, et dans lequel le modèle d'état prend en compte, lors du calcul de la valeur de la température, au moins les grandeurs de convertisseur suivantes : tensions de l'accumulateur d'énergie, états de coupure et fréquences de coupure d'au moins certains modules (SM) de coupure, une tension de bras et un courant de bras du bras (5-10) du convertisseur, ainsi qu'une valeur de consommation de redondance, qui indique combien de modules de coupure dans un bras de convertisseur sont déjà tombés en panne ou défaillants.

2. Procédé suivant la revendication 1, dans lequel on affecte une probabilité d'évènement à la durée de vie restante.

3. Procédé suivant l'une des revendications précédentes, dans lequel on répète la détermination des valeurs de la température à des intervalles de temps de moins de 1 seconde.

4. Procédé suivant l'une des revendications précédentes, dans lequel on détermine la hauteur de l'élévation de la température à partir d'une différence entre deux valeurs de la température.

5. Procédé suivant l'une des revendications précédentes, dans lequel on effectue l'estimation de la durée de vie restante en tenant compte d'un modèle de durée de vie de l'interrupteur (HL) à semiconducteur.

6. Procédé suivant l'une des revendications précédentes, dans lequel, si la durée de vie restante estimée passe en-dessous d'une valeur de seuil donnée à l'avance, on émet un signal pour une instruction d'entretien.

7. Procédé suivant l'une des revendications précédentes, dans lequel on détermine des valeurs de la température sur un dispositif (LTB) extérieur de traitement de données en passant par un réseau de données extérieur au convertisseur et on effectue l'estimation de la durée de vie restante au moyen du dispositif (LTB) extérieur de traitement de données.

8. Procédé suivant l'une des revendications précédentes, dans lequel on ajuste les valeurs de la température pour l'extension de la base de données par des valeurs de la température d'autres convertisseurs.

9. Convertisseur (2), qui comprend des bras (5-10) de convertisseur, dans lequel chaque bras (5-10) de convertisseur a des modules (SM) de coupure ayant respectivement plusieurs interrupteurs (HL) à semiconducteur et un accumulateur (C) d'énergie, **caractérisé par**
au moins un dispositif (13) de traitement de données, qui est agencé pour effectuer un procédé suivant l'une des revendications 1 à 8.
